# EUROPEAN PATENT SPECIFICATION

(11) **EP 3 036 294 B1**
(45) Date of publication and mention of the grant of the patent: **12.06.2019**
(21) Application number: 14755355.6
(22) Date of filing: 21.08.2014
(51) Int. Cl.: C09D 11/52, C09D 5/24, H05K 1/09, H05K 3/02, H05K 3/10

(54) **CONDUCTIVE PASTES OR INKS COMPRISING NANOMETRIC CHEMICAL FRITS**
LEITFÄHIGE PASTEN ODER TINTEN AUS NANOSKALIGEN CHEMISCHEN FRITTEN
PÂTES OU ENCRES CONDUCTRICES COMPRENANT DES FRITTES CHIMIQUES NANOMÉTRIQUES

(30) Priority: 22.08.2013 IT MI20131398
(43) Date of publication of application: 29.06.2016
(73) Proprietor: Vispa S.r.l., 17014 Cairo Montenotte (SV) (IT)
(72) Inventor: GUNNELLA, Alessandro, I-17014 Cairo Montenotte (SV) (IT); MAGNANELLI, Stefano, I-17014 Cairo Montenotte (SV) (IT); POGGI, Antonio, I-17014 Cairo Montenotte (SV) (IT); COSTA, Chiara, I-17014 Cairo Montenotte (SV) (IT); SPOTTI, Davide, I-31100 Treviso (IT)
(74) Representative: Allaix, Roberto
(86) International application number: PCT/EP2014/067803
(87) International publication number: WO 2015/024990

(56) References cited:
- EP-A2- 0 747 912
- WO-A1-2011/035015
- WO-A1-2012/071287
- WO-A1-2012/075267
- WO-A2-2012/071289
- JP-A- 2011 171 673

## Description

### FIELD OF THE INVENTION

The present invention relates to conductive pastes or inks, which may be used to form conductive elements on the surface of a substrate.

### PRIOR ART

The basic structure of a conventional (first generation) solar cell comprises typically a lamina of semiconductor material, an antireflective layer formed on the surface of said lamina which is exposed to sunlight, and two electrodes each arranged on each of the two opposite sides of said lamina.

Typically, solar cells have a square or rectangular shape, with right-angled or rounded corners and dimensions ranging between 10 and 16 centimeters.

The lamina most used hitherto for the production of solar cells is made of crystalline silicon, since this material provide the best compromise between production cost and conversion efficiency of the solar cell. The conversion efficiency of the solar cell is defined by the ratio between the electric energy produced and the energy acting on the cell in the form of solar radiation.

The crystalline silicon lamina, commonly called silicon wafer or simply wafer, has a thickness of between 120 micrometers and 350 micrometers and is very fragile. Consequently, the solar cell is laminated on a substrate of glass or other material located on the side exposed to the sun and is encapsulated in an elastic and transparent polymeric film provided with an insulating and opaque, polymeric, backing sealant in order to increase its resistance over time.

Two layers may be distinguished in the crystalline silicon wafer: the first layer, which is exposed to the sun, called emitter layer, is formed by doping the silicon for example with phosphorus so as to obtain a region with an excess of electrons (n region), and the second layer underlying the first layer, called semiconductor substrate, is formed by doping the silicon for example with boron so as to obtain a region with an excess of holes (p region). A p-n junction is formed at the interface between the n region and the p region and allows the passage of electrons from the p region to the n region.

The antireflective layer is applied onto the sun-exposed surface of the emitter layer in order to reduce the fraction of solar radiation which is reflected externally and cannot be used for energy production. This layer is typically composed of silicon oxide and/or silicon nitride (SiNₓ).

Alternatively, cells have been developed where the volumetric ratio between the doped regions is reversed, and likewise the type of doping of the side of the cell exposed to solar radiation is reversed.

A conductive paste or a conductive ink is however applied onto the antireflective layer, typically by means of a screen or ink-jet printing process, in order to form the first frontal electrode (upper electrode).

The conductive pastes or inks contain particles of conductive metal, for example silver. When solar cells with side dimensions of between 10 and 16 centimeters are used, the quantity of silver applied onto a solar cell is between about 0.10 and 0.20 grams.

Typically, the upper electrode is in the form of a grid which must ideally achieve a compromise between the least possible shadowing of the surface exposed to the sun (so as not to prevent the photons striking the semiconductor suface) and the greatest possible capacity for collecting the electrical charges generated by said semiconductor substrate as a result of the photovoltaic effect. Said grid is formed by thin metal lines (or "fingers") which collect the current produced and convey it to the collectors (or "bus bars") which take the form of wider metal lines arranged at right angles to the first lines. Each wafer has, formed thereon, numerous thin metal lines and two or more bus bars which are also used to connect together the solar cells through a soldering process.

Alternatively, by means of MWT (metal wrap through) technology, the fingers which form the upper electrode are designed to converge onto the collector holes passing through the solar cell. By means of this technology it is possible to achieve a more efficient design of the final photovoltaic module, which is of the so-called second generation "back contact" type.

The second electrode located on the rear side of the wafer (lower electrode) is formed by applying one or more conductive pastes or inks containing conductive metal particles, typically aluminum, silver or mixtures thereof, onto the surface of the wafer which is not exposed to sunlight, typically by means of a screen printing process.

Typically, the lower electrode is a continuous layer since there is no need to adsorb light as on the front surface of the wafer.

The pastes and the inks applied onto the antireflective layer and onto the surface of the wafer which is not exposed to sunlight are dried on the substrate and activated by means of a firing process in high-temperature furnaces.

In addition to the conductive metal particles, the pastes and the inks conventionally used to form the upper electrode also contain a glass component ("glass frit") which, during the firing process, melts and corrodes the antireflective layer, thus allowing the conductive metal particles to come into contact with the emitter layer.

The pastes and the inks are typically in the form of a dispersion. The conductive metal particles and the glass frits are formulated using binders and solvents which make the paste and the ink suitable for the printing process.

The requisites which must be satisfied by a conductive paste have been described by G. Schubert in his thesis "*Thick film metallisation of* *crystalline silicon solar cells. Mechanisms*, *models and applications*"*.*

In particular, in order to reduce the contact resistance between the conductive metal particles and the emitter layer and improve the efficiency of the final solar cell, the glass frits must melt and form a smooth, homogeneous, conductive glass which is as thin as possible, without penetrating the interface of the p-n junction.

Moreover, the glass frits should melt a part of the silver particles during the firing process inside the furnaces so that, following cooling, the silver precipitates as fine crystallites at the interface between the conductive glass and the emitter layer, together with the other metal particles from the frit (for example, lead, bismuth and antimony particles) which help make the glass conductive.

One of the advantages of conventional glass frits is that it is possible to vary their chemical composition (for example by varying the percentages of oxides used) so as to adjust their properties such as, for example the melting temperature, viscosity and heat expansion coefficient.

The glass frits are conventionally obtained by mixing glass precursor powders, for example borosilicates, aluminosilicates and oxides of silicon, boron, aluminum, cadmium, barium, calcium, tellurium, bismuth, antimony, thallium, zinc, sodium, lithium, lead and the like.

The mixture is melted inside crucibles which are suitable for obtaining a homogeneous liquid mass which is rapidly cooled to obtain the corresponding glass. The glass thus obtained is subjected to grinding in order to reduce it to glass fragments with a particle size suitable for being used in the pastes or inks.

By means of the conventional grinding processes it is possible to obtain glass frits with dimensions of between about 200 nanometers and about 20 micrometers and with a fragmented form typical of broken glass.

The dimensional distribution curves of the glass frits obtained by means of grinding are typically wide and asymmetrical, with a peak at about 1 micrometer and a tail end formed by the glass frits with dimensions greater than 10 micrometers. Determination of the dimensional distribution curves is performed using standard methods, as described, for example, in A. Jillavenkatesa et al., "NIST Recommended Practice Guide: Particle Size Characterization", NIST SP - 960-1, January 2001.

However, the pastes and the inks employed for the production of solar cells must have a fine and homogeneous consistency, so as not to block up the openings of the screens or of the dispenser nozzles or of the ink-jet printers. Consequently, the components of the pastes and inks, for example the conductive metal particles, the glass frits and any other additives, must have dimensions smaller than 10 micrometers, preferably smaller than 2 micrometers, and advantageously smaller than one micrometer.

When silver is used as conductive metal, the particles of silver are typically obtained using chemical precipitation processes, for example chemical reduction.

Moreover, it is a common practice to reduce the size of the glass frits using grinding and/or granulometric separation processes, the latter being applied in particular when it is required to obtain particles with dimensions smaller than a micrometer.

As regards the additives, international patent application WO2011/035015 describes a conductive paste comprising silver in powder form, glass frits and an inorganic additive with nanometric dimensions, selected from metallic zinc, zinc alloys or mixtures of metallic zinc and zinc oxide. All the components of said conductive paste are dispersed in an organic medium.

Finally, international patent application WO 2011/060341 describes a conductive paste containing silver particles, glass particles, an organic vehicle and at least one inorganic additive which may be tantalum pentoxide or metal particles belonging to the gold and platinum groups having a particle diameter from about 1 nm to about 1 µm. Said paste is able to ensure a better adhesion of the electrode to the cell and a better electron transmission.

The problem of occlusion is particularly evident when conductive inks are used in the metallization processes involving ink-jet printing, since the particles which form the conventional conductive inks may occlude the supply nozzles and the dispensers.

Consequently, it is required to use conductive inks which have components with dimensions smaller than one micrometer.

### SUMMARY OF THE INVENTION

The Applicant has considered the problem of preparing conductive pastes or inks having improved efficiency and printability compared to those known in the art.

Initially the Applicant considered the problem of preparing conductive pastes or inks with a finer and more homogeneous consistency, eliminating the glass frits with dimensions greater than 10 micrometers.

Furthermore the Applicant considered the problem of preparing glass frits characterized by a narrow and symmetrical dimensional distribution curve.

In particular, the Applicant considered the problem of preparing glass frits which have dimensions smaller than 1 micrometer.

The Applicant noted that the methods used conventionally to reduce the dimensions of the glass frits are not simple to implement, require a high degree of expertise and may have undesirable polluting effects and are very costly.

The Applicant has therefore tried to develop a material with characteristics such as to be able to be used in conductive pastes or inks, avoiding the processes used conventionally in the production of conventional glass frits.

Surprisingly, the Applicant has found that it is possible to use colloidal dispersions of inorganic salts in the preparation of conductive pastes or inks.

Advantageously, said colloidal dispersions are prepared on an industrial level by means of a direct, solvent-based, chemical synthesis process which has a low production cost.

Advantageously, said colloidal dispersions are formed by particles having dimensions smaller than 1 micrometer. In other words, said particles have nanometric dimensions.

Advantageously, said colloidal dispersions are formed by particles having a homogeneous particle size. In other words, the dimensional distribution curve of said particles is narrow and symmetrical.

Advantageously, said colloidal dispersions are formed by particles having a spheroidal shape.

Surprisingly, the particles which form said colloidal dispersions allow the preparation of conductive pastes or inks which have a consistency which is finer and more homogeneous than those containing the conventional glass frits.

The particles which form the aforementioned colloidal dispersions are obtained by means of direct chemical synthesis, in a suitable solvent or mixture of solvents, and may replace, completely or partly, the glass frits during the preparation of conductive pastes or inks. Consequently, said particles have been defined as "chemical frits" since, once formulated in the conductive pastes or inks, also as a single inorganic additive in addition to the conductive particles, they are capable, differently from the additives added to the glass frits, to perform the same function as the glass frits, obtaining high-performance photovoltaic cells.

According to a first aspect, the present invention therefore relates to conductive pastes or inks comprising conductive metal particles, preferably with dimensions smaller than 10 micrometers, at least one solvent and at least one organic additive, characterized in that it comprises chemical frits wherein at least 95%, by number, of the particles of said chemical frits have dimensions smaller than 1 micrometer.

The Applicant has found that the paste or ink according to the present invention may be advantageously used in screen printing processes, without blocking the openings of the screens.

The Applicant has found that, when the conductive metal particles also have dimensions smaller than 1 micrometer, the paste or ink according to the present invention may be advantageously used in the metallization processes employing ink-jet printing.

The Applicant has found that the conductive paste or ink according to the present invention may be advantageously used in the production of solar cells.

The Applicant has found that, advantageously, during the firing process in the furnaces, the chemical frits with nanometric dimensions and a spheroidal shape mix more thoroughly and homogeneously with the conductive metal particles and consequently percolate more easily and more homogeneously through the conductive metal particles than the glass frits conventionally used.

Consequently, during the firing process in the furnaces, the chemical frits form, by means of reaction with the silicon substrate, a smooth and homogeneous glass at the interface with the bulk wafer and reduce the contact resistance between the conductive metal particles and the wafer emitter layer.

Surprisingly, the Applicant has found that the solar cells obtained using the paste or the ink according to the present invention have a better conversion efficiency than the solar cells prepared using the conductive pastes or inks comprising the conventional glass frits.

Advantageously, the Applicant has also found that, for the same conversion efficiency, the solar cells obtained using the conductive paste or ink according to the present invention have a smaller specific cost, all other factors or components of the cells being the same.

According to a second aspect, the present invention relates to a solar cell in which the upper electrode is obtained, integrally or partially at least in the part in direct contact with the anti-reflective layer and emitter, using the paste or ink according to the present invention.

The Applicant has found that the paste or ink according to the present invention may be used in order to form a conductive element on the surface of a substrate.

Therefore, according to a third aspect, the present invention relates to a method for forming a conductive element on the surface of a substrate, comprising a step of applying the conductive paste or ink according to the present invention on said surface and a step of sintering said conductive paste or ink.

### BRIEF DESCRIPTION OF THE FIGURES

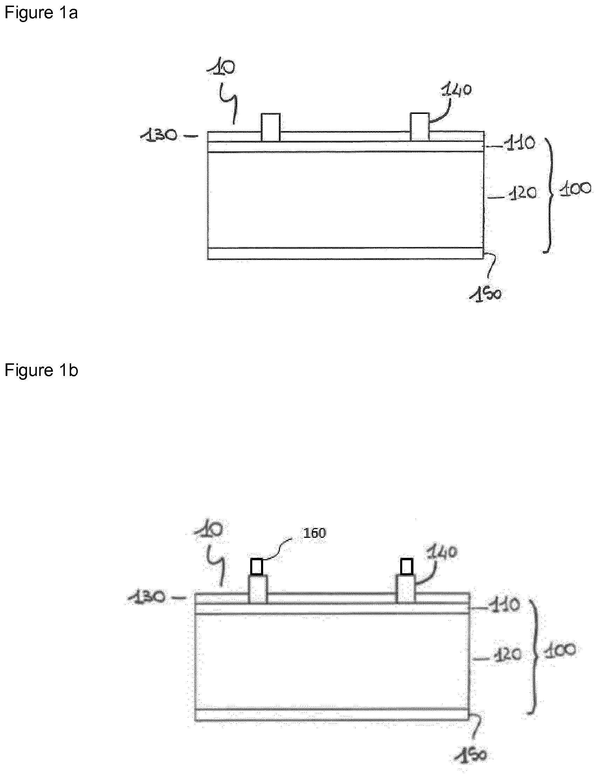

Figure 1a shows a cross-sectional view of a solar cell according to a first embodiment of the present invention.
Figure 1a shows a cross-sectional view of a solar cell according to a second embodiment of the present invention.

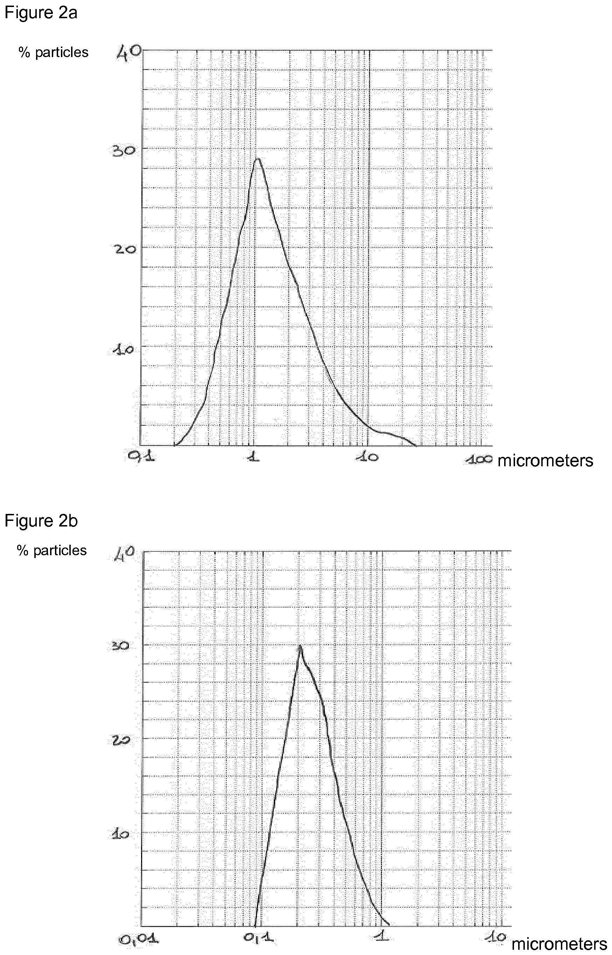

Figure 2a shows an exemplary illustration of the dimensional distribution of the glass frits prepared using conventional methods.
Figure 2b shows an exemplary illustration of the dimensional distribution of the chemical frits prepared as described in the present invention.
Figure 3 shows a photograph (magnification factor: 50,000x), obtained using a scanning electron microscope (SEM), of the dispersion of the chemical frits obtained in Example 3.
Figure 4 shows a photograph (magnification factor: 1000x), obtained using a transmitted-light optical microscope, of particles of PbTeO₃·2H₂O obtained in Example 4.
Figure 5 shows a photograph (magnification factor: 40,000x), obtained using a scanning electron microscope (SEM), of the dispersion of the chemical frits obtained in Example 4.
Figure 6 shows a photograph (magnification factor: 85,000x), obtained using a transmission electron microscope (TEM), of the dispersion of the chemical frits obtained in Example 4.
Figure 7 shows a photograph (magnification factor: 30,000x), obtained using a transmission electron microscope (TEM), of the dispersion of the chemical frits obtained in Example 4.
Figure 8 shows the dimensional distribution curve, measured using the dynamic light scattering (DLS) method, for the chemical frits prepared as described in Example 4.

### DETAILED DESCRIPTION OF THE INVENTION

For the purposes of the present description and the claims which follow, the expression "glass frit" indicates particles of glass obtained using the conventional glass technology methods, for example by means of mixing of oxide powders, melting and cooling thereof, followed by grinding and selection of said flakes with the desired particle size.

For the purposes of the present description and the claims which follow, the expression "chemical frit" indicates particles of inorganic or organic metal salts with nanometric dimensions, obtained by means of direct chemical synthesis in a suitable solvent.

The chemical frits according to the present invention are obtained by means of chemical synthesis from solvent in the form of salts and, by their nature, unlike glass, obey the laws of classical chemical stoichiometry. In other words, their composition may be expressed by means of a precise chemical formula classifiable as a salt.

In particular, for the purposes of the present invention, the chemical frits are obtained from the synthesis process with the dimensions and compositions suitable for being used directly, as such, in the formulation of conductive pastes and/or inks, without having to carry out on said particles any physical treatment for granulometric separation or reduction of the particle size, such as grinding, sifting or sedimentation, and no heat treatment at temperatures other than room temperature.

Moreover, for the purposes of the present invention, the chemical frits are able to be used in the formulation of conductive pastes and/or inks as a single inorganic component, in addition to the conductive particles, also entirely in place of the glass frits.

The measurement of the dimensions, the morphology and the dimensional homogeneity of the chemical frit particles according to the present invention may be performed using numerous techniques, in particular transmitted-light optical microscopy, scanning electron microscopy (SEM) and transmission electronic microscopy (TEM) and dynamic light scattering (DLS), as described, for example, in Jillavenkatesa et al., "NIST Recommended Practice Guide: Particle Size Characterization", NIST SP - 960-1, January 2001.

For the purposes of the present description and the claims which follow, the expressions "dimensions smaller than" and "nanometric dimensions" refer to the maximum dimension of the particle under consideration. The maximum dimension of a particle depends on the shape of the particle. For example, in the case of spherical or substantially spherical particles, the maximum dimension coincides with the diameter of the particle, while, in the case of needle-shaped particles, the maximum dimension coincides with the length and, in the case of other types of particles, the maximum dimension coincides with a diagonal or a side.

Therefore, for example, the expression "dimensions smaller than 1 micrometer" means that the maximum dimension of the particle considered is smaller than 1 micrometer.

According to a first aspect, the present invention relates to a conductive paste or ink comprising conductive metal particles, at least one solvent and at least one organic additive, characterized in that it comprises chemical frits in which at least 95%, by number, of the particles of said chemical frits have dimensions smaller than 1 micrometer.

Preferably, at least 98%, by number, of the particles of said chemical frits, and more preferably at least 99%, by number, of the particles of said chemical frits, have dimensions smaller than 1 micrometer.

According to a preferred aspect, at least 95%, by number, of the particles of said chemical frits have dimensions smaller than 500 nm. More preferably, at least 98%, by number, of the particles of said chemical frits have dimensions smaller than 500 nm. Even more preferably, at least 99%, by number, of the particles of said chemical frits have dimensions smaller than 500 nm.

According to a further preferred aspect, at least 95%, by number, of the particles of said chemical frits have dimensions smaller than 200 nm. More preferably, at least 98%, by number, of the particles of said chemical frits have dimensions smaller than 200 nm. Even more preferably, at least 99%, by number, of the particles of said chemical frits have dimensions smaller than 200 nm.

Determination of the dimensional distribution curves is performed using standard methods, as described, for example, in A. Jillavenkatesa et al., "NIST Recommended Practice Guide: Particle Size Characterization", NIST SP - 960-1, January 2001. In particular, determination of the particle distribution curve, and therefore determination of the number of particles having dimensions smaller than a given value, for example 1 micrometer, may be performed by means of the method of dynamic light scattering (DLS), a practical and fast standard method, using equipment known in the art, for example the Malvern Zetasizer Nano ZS apparatus, which provides an overestimation of the real dimension of the solid particles by means of determination of the hydrodynamic diameter.

Preferably, said chemical frits have a spheroidal shape. As is known in the art, the term "spheroidal" is understood as meaning a form similar to a sphere, but not perfectly round and/or with a surface which is not perfectly regular.

Preferably, said chemical frits comprise a simple salt, a mixed salt or a complex salt, formed by at least one metal cation and at least one inorganic or organic anion.

Advantageously, said chemical frits comprise a simple salt, a mixed salt or a complex salt, formed by at least one metal cation and at least one inorganic anion.

Typically, said at least one metal cation is selected from the group comprising metals of group III, preferably thallium (TI), of group IV, preferably lead and tin (Pb and Sn), of group V, preferably bismuth and antimony (BI and Sb) and/or of block d, preferably nickel, copper, zinc and silver (Ni, Cu, Zn and Ag).

Preferably, said at least one metal cation is selected from the group comprising lead, tin, zinc, bismuth, antimony and silver.

Typically said at least one anion is selected from the group comprising carbonate, bicarbonate, borate, acetate, selenate, selenite, tellurate, tellurite, vanadate, silicate, fatty acid anions; and hydrates thereof.

Preferably, said at least one anion is selected from the group comprising borate, tellurate, tellurite and vanadate.

Advantageously, said chemical frits have a melting temperature lower than 900°C, preferably lower than 750°C, and more preferably lower than 600°C.

Preferably, the paste or ink according to the present invention comprises from 0.1% to 7% by weight, more preferably from 1.5% to 3.5 % by weight, of said chemical frits with respect to the total weight of said paste or ink.

In an alternative embodiment, the paste or ink according to the present invention comprises said chemical frits mixed with conventional glass frits. In this case, the paste or ink according to the present invention comprises preferably from 0.05% to 7% by weight of said chemical frits with respect to the total weight of said paste or ink and a percentage by weight, intentionally added, of said glass frits with respect to the total weight of said paste or ink greater than zero, and preferably between 0.01% and 3.5%.

Advantageously, said chemical frits may be prepared using methods known in the art by means of which it is possible to obtain simple salts, mixed salts or complex salts, having dimensions smaller than 1 micrometer, for example in the form of colloidal dispersions or floccules.

Said chemical frits are prepared by means of direct chemical synthesis in the solvent phase or vapor phase.

In a preferred embodiment, said chemical frits are prepared by means of direct chemical synthesis in the solvent phase for example as described by Lenher and Wolesensky (Journal of American Chemical Society, 1913, 35, 718-733).

Preferably, said conductive metal is selected from the group comprising Ag, Cu, Pd, Zn, Ni, Sn, Al, Bi, Sb, their alloys and mixtures thereof. More preferably, said conductive metal is Ag.

Preferably, the paste or ink according to the present invention comprises from 65% to 95% by weight, more preferably from 70% to 90% by weight, of said conductive metal particles with respect to the total weight of said paste or ink.

Preferably said conductive metal particles have a diameter (D₉₀) measured by means of a scanning electron microscope (SEM) smaller than 2.00 micrometers, more preferably smaller than 1.60 micrometers and even more preferably smaller than 1.30 micrometers.

The diameter (D₉₀), corresponding to the diameter below which 90% of the particle population lies, is a characteristic of the particles well-known to persons skilled in the art, as are the methods for determining said diameter. For example, the software equipping the DLS apparatus, such as the Malvern Zetasizer Nano ZS apparatus, automatically provides the measurements of these parameters.

Preferably, said solvent is selected from the group comprising water, alcohols, polyols, ethers, esters, hydrocarbons and mixtures thereof. More preferably, said organic solvent is selected from α-terpineol, β-terpineol, diethylene glycol monomethyl ether acetate, 2,2,4-trimethyl-1,3-pentanediol monoisobutyrate, butyl carbitol acetate, or mixtures thereof. Even more preferably, said organic solvent is diethylene glycol monomethyl ether acetate.

Preferably, the paste or ink according to the present invention comprises from 2% to 20% by weight, more preferably from 5% to 15 % by weight, of said organic solvent or solvent mixture with respect to the total weight of said paste or ink.

Preferably, said organic additive is selected from the group comprising organic binders and surfactants.

Preferably, said organic binder is selected from the group comprising derivatives of cellulose, polyvinyl alcohols, polyvinyl butyrals, polyvinylpyrrolidones, acrylic resins and phenolic resins. More preferably, said organic binder is a derivative of cellulose, for example ethyl cellulose, or an acrylic resin, for example polyacrylates, such as methyl methacrylate, butyl methacrylate and copolymers thereof.

Preferably, said surfactant is selected from the group comprising polyethylene oxides, optionally derivatized, polyethylene glycols optionally derivatized, polyethylene glycol acetic acid, lauric acid, oleic acid, capric acid, myristic acid, linolic acid, stearic acid, palmatic acid, azelaic acid, stearate salts, palmitate salts and mixtures thereof. More preferably, said surfactant is polyethylene glycol p-(1,1,3,3-tetramethylbutyl)-phenyl ether.

Preferably, the paste or ink according to the present invention comprises from 0.1% to 1.2% by weight, more preferably from 0.3% to 1 % by weight, of said organic binder with respect to the total weight of said paste or ink.

Preferably, the paste or ink according to the present invention comprises from 0.001% to 0.1% by weight, more preferably from 0.005% to 0.05% by weight, of said surfactant with respect to the total weight of said paste or ink.

The paste or ink according to the present invention may be prepared using methods known in the art, such as, for example, mixing, rolling or the like.

Advantageously, using such methods it is possible to provide a paste or an ink which are homogeneous, such that they may be used in a screen or ink-jet printing process.

In one embodiment, the paste or ink according to the present invention are prepared by mixing the conductive metal particles, the chemical frits and at least one organic additive in an organic solvent.

Optionally, the paste or ink according to the present invention may be further refined in a rotating-cylinder mill, using methods known in the art.

In a preferred embodiment, the paste or ink according to the present invention does not require further refinements.

According to a second aspect, the present invention relates to a solar cell comprising a wafer of semiconductor material, an antireflective layer, an upper electrode and a lower electrode, characterized in that at least said upper electrode is formed by (i) applying on said antireflective layer a conductive paste or ink comprising conductive metal particles, at least one solvent, at least one organic additive and chemical frits, wherein at least 95%, by number, of the particles of said chemical frits have dimensions smaller than 1 micrometer, and (ii) sintering said conductive paste or ink.

Preferably, at least 98%, by number, of the particles of said chemical frits, and more preferably at least 99%, by number, of the particles of said chemical frits, have dimensions smaller than 1 micrometer.

According to a preferred aspect, at least 95%, by number, of the particles of said chemical frits have dimensions smaller than 500 nm. More preferably, at least 98%, by number, of the particles of said chemical frits have dimensions smaller than 500 nm. Even more preferably, at least 99%, by number, of the particles of said chemical frits have dimensions smaller than 500 nm.

According to a further preferred aspect, at least 95%, by number, of the particles of said chemical frits have dimensions smaller than 200 nm. More preferably, at least 98%, by number, of the particles of said chemical frits have dimensions smaller than 200 nm. Even more preferably, at least 99%, by number, of the particles of said chemical frits have dimensions smaller than 200 nm.

Preferably, said chemical frits have a spheroidal shape.

Preferably, said chemical frits comprise a simple salt, a mixed salt or a complex salt, formed by at least one metal cation and at least one inorganic or organic anion.

Advantageously, said chemical frits comprise a simple salt, a mixed salt or a complex salt, formed by at least one metal cation and at least one inorganic anion.

Typically, said at least one metal cation is selected from the group comprising metals of group III, preferably thallium (TI), of group IV, preferably lead and tin (Pb and Sn), of group V, preferably bismuth and antimony (BI and Sb) and/or of block d, preferably nickel, copper, zinc and silver (Ni, Cu, Zn and Ag).

Preferably, said at least one metal cation is selected from the group comprising lead, tin, zinc, bismuth, antimony and silver.

Typically said at least one anion is selected from the group comprising carbonate, bicarbonate, borate, acetate, selenate, selenite, tellurate, tellurite, vanadate, silicate, fatty acid anions; and hydrates thereof.

Preferably, said at least one anion is selected from the group comprising borate, tellurate, tellurite and vanadate.

Advantageously, said chemical frits have a melting temperature lower than 900°C, preferably lower than 750°C, and more preferably lower than 600°C.

Preferably, the paste or ink according to the present invention comprises from 0.1% to 7% by weight, more preferably from 1.5% to 3.5 % by weight, of said chemical frits with respect to the total weight of said paste or ink.

In an alternative embodiment, the paste or ink according to the present invention comprises said chemical frits mixed with conventional glass frits. In this case, the paste or ink according to the present invention comprises preferably from 0.05% to 7% by weight of said chemical frits with respect to the total weight of said paste or ink and a percentage by weight, intentionally added, of said glass frits with respect to the total weight of said paste or ink greater than zero, and preferably between 0.01% and 3.5%.

With reference to Figure 1, a solar cell 10 according to the present invention comprises a wafer 100 in which an emitter layer 110 of type n silicon, obtained by means of doping with phosphorus, is formed and a semiconductor substrate 120 of type p silicon, obtained by means of doping with boron, is formed underneath said emitter layer 110.

In an alternative embodiment, the emitter layer 110 could be made of type p silicon, and the semiconductor substrate 120 could be made of type n silicon.

Said wafer 100 has a square or rectangular shape with a side size of between 10 cm and 16 cm and a thickness of between 120 micrometers and 350 micrometers.

In one embodiment, the surface of the emitter layer 110 is smooth.

In an alternative embodiment, the surface of said emitter layer 110 may have a structure of the concave/convex or pyramidal type (not shown in Figure 1), in order to reduce the reflected component of the incident sunlight and increase absorption of the sunlight, thus improving the conversion efficiency of the solar cell.

An antireflective layer 130 is present on the upper surface of said emitter layer 110. Said antireflective layer 130 is applied using methods known in the art, for example chemical vapor deposition and plasma-assisted chemical vapor deposition.

The paste or ink according to the present invention may be used to form an upper electrode 140 connected electrically to said emitter layer 110 and/or a lower electrode 150 connected electrically to said semiconductor substrate 120.

The lower electrode 150 may be a continuous layer. Alternatively, said lower electrode 150 may be in the form of strips or sections (not shown in Figure 1).

In a preferred embodiment, the paste or ink according to the present invention are used to form integrally the upper electrode 140. Alternatively, a further layer 160 of different conductive paste or ink is mounted on the part of the electrode in contact with the emitter layer 110 (as shown in Figure 1b).

The application (i) of the paste or ink according to the present invention on said antireflective layer 130 is performed using conventional methods, for example by means of impregnation, dipping, pouring, dripping, injection, spraying, knife coating, tampography, brushing or printing, or a combination thereof.

In a preferred embodiment, the paste or ink according to the present invention is applied by means of screen printing, ink-jet printing, offset printing, pad printing and relief printing. The paste or ink according to the present invention may be used in other application techniques, such as, for example, dispensing deposition and syringe or nozzle extrusion.

Advantageously, in order to form the upper electrode, said paste is applied by means of screen printing, using screens having openings with dimensions ranging from about 20 micrometers to about 80 micrometers.

Advantageously, in order to form the upper electrode, said ink is applied by means of ink-jet printing, using nozzles having dimensions also smaller than 20 micrometers.

In a preferred embodiment, a paste or ink based on aluminum, silver or mixtures thereof is applied onto the surface of the semiconductor substrate 120 not exposed to the sunlight, using conventional methods, for example by means of impregnation, dipping, pouring, dripping, injection, spraying, knife coating, brushing or printing, or a combination thereof, in order to form said lower electrode 150.

Sintering (ii) of the paste or the ink is performed in two steps.

In the first step (drying), after each paste or ink application step, the solar cells are placed on a conveyor belt and dried by means of IR or a hot air flow in order to eliminate the solvent and most of the organic components. Advantageously, said drying process has a duration of between 1 minute and 30 minutes.

The last drying process is followed by the second step, or the definitive paste or ink firing or sintering process. Advantageously, said firing process has a duration of between 0.5 and 10 minutes and is carried out at a temperature of between 500°C and 950°C.

Advantageously, said sintering process is generally performed in air.

The firing or sintering step (ii) is followed by cooling of the obtained solar cells.

Simultaneous firing of the upper and lower electrodes is advantageous if the pastes or the inks applied on both surfaces can be treated in very similar conditions.

In an alternative embodiment, a first paste or ink is applied onto the surface of the wafer which is not exposed to the sunlight in order to form the lower electrode 150, dried by means IR and subjected to the furnace firing step. After cooling, a second paste or ink is applied onto the surface of the antireflective layer in order to form the upper electrode 140, dried by means of IR and then subjected to the second furnace firing step.

As described above, said firing or sintering process allows the chemical frits present in the paste or the ink of the present invention to melt and corrode in the liquid state the antireflective layer 130, thus promoting the formation of the electrical contact between the conductive metal particles and the emitter substrate 110.

Multiple solar cells according to the present invention may be connected electrically together using methods well known in the art in order to form a photovoltaic module.

For example, in order to connect the solar cells together, silver soldering points or lines, suitable for the subsequent soldering of a metal strip, are formed on the bottom surface of the wafer.

Preferred photovoltaic modules according to the present invention have a rectangular shape and are known as photovoltaic solar panels.

Finally, according to a third aspect, the present invention relates to a method for forming a conductive element on the surface of a substrate which comprises (a) a step of applying on said surface a conductive paste or ink comprising conductive metal particles, at least one organic solvent, at least one organic additive and chemical frits, wherein at least 95%, by number, of the particles of said chemical frits have dimensions smaller than 1 micrometer, and (b) a step of firing or sintering the conductive paste or ink.

Preferably, said conductive element is an electrode, a printed circuit board, a conductive path or a resistor.

Preferably, said substrate is a polymeric substrate, a paper sheet, an insulating substrate, like glass or ceramic, or a semiconductor material. Preferably, said semiconductor material is silicon.

Preferably, said step (a) is performed by means of impregnation, dipping, pouring, dripping, injection, spraying, knife coating, brushing or printing, or a combination thereof.

Preferably, said step (b) is performed by means of firing or sintering in belt furnaces.

Preferably, said firing process has a duration of between 0.5 and 30 minutes, more preferably between 1 and 20 minutes.

Preferably, said firing process is performed at a temperature of between 400°C and 1000°C, more preferably between 500°C and 950°C,
The following examples are intended to illustrate the present invention without however limiting its scope.

### EXAMPLES

### EXAMPLE 1 (comparison)

Preparation of a conductive paste comprising chemical frits based on pure lead salt with micrometric dimensions and obtained by means of direct solvent-based chemical synthesis (as described in G. Salomone, "Guida pratica per la preparazione dei prodotti chimici - prodotti minerali" Lavagnolo Ed. 1950, page 166).

Solution A was obtained by dissolving 100 g of Pb(NO₃)₂ in 195 g of deionized water. Solution B was obtained by dissolving 61 g of Na₂B₄O₇ in 1187 g of deionized water.

Solution A was then poured into solution B with vigorous stirring until a white precipitate of PbBO₂·nH₂O was obtained.

The precipitate was separated by means of filtration with a Buchner filter, washed with deionized water in order to remove the soluble salts, for example sodium nitrate, and finally dried until a constant weight was achieved.

The solid powder of PbBO₂ thus obtained consisted of grains with dimensions ranging from hundreds of nanometers to about 30 micrometers.

The solid powder was first ground and then sieved using a Retsch sieve with mesh size of 10 micrometers, thus obtaining only the powder fraction of PbBO₂ with dimensions smaller than 10 micrometers.

The solid powder was used to prepare a conductive paste with the following composition:

| Component | Concentration by weight |
|---|---|
| PbBO₂ | 2.25% |
| Silver powder | 86.02% |
| Binder | 0.82% |
| Surfactant | 0.01% |
| Solvent | 10.9% |

| | |
|---|---|
| Silver powder: D90 < 1.55 micrometers determined by means of SEM Binder: cellulose acetate Surfactant: polyethylene glycol p-(1,1,3,3-tetramethylbutyl)-phenyl ether (Triton X) Solvent: butyl CARBITOL™ acetate (diethylene glycol n-butyl ether acetate - DEGMA) | |

All the components were mixed together and the final paste was refined in a three roll mill gradually moving the cylinders closer together to a nominal distance of 5 micrometers.

The paste thus obtained was used to prepare solar cells.

Commercially available wafers of p type silicon, with a side size of 156 mm and sheet resistivity of solar n type side of 75 mOhm/cm², were used.

For printing of the thin metal lines ("fingers") which form the upper electrode a screen with 80-micrometer openings, having a standard geometry for 3 bus bars silicon solar cells, was used in order to obtain solar cells with 0.2 grams of silver paste printed on the emitter layer.

1.5 g of a commercially available aluminum paste (PEMCO AL 3302 PC) were printed on the back surface of each cell.

Silver bus bars printed with silver paste Chimet 2711 SC on the back surface were used in order to complete the solar cell in a manner perfectly comparable to the process for manufacturing commercial cells.

All the cells were dried completely before the furnace firing process.

In order to find the best firing conditions, the firing process was conducted in a furnace equipped with an RTC conveyor belt, model PV-614X, using different speeds of the conveyor belt and different temperature peaks.

The best conditions proved to be the following:
- peak temperature: 955°C
- conveyor belt speed: 600 cm/min.

The electrical parameters obtained for 20 solar cells fired in the aforementioned conditions were measured using a Berger cell tester CL4A-1.3600 R&D.

The average value for each parameter is shown in Table 1.

### EXAMPLE 2 (comparison)

Preparation of a conductive paste comprising glass frits based on PbO and B₂O₃ and produced by Ceradyne VIOX (VIOX Code 24125).

The glass frits were ground first in a rotating blade mill and then in a rotating-cylinder mill and finally sieved using a sieve with mesh size of 10 micrometers so as to obtain 100% particles with dimensions smaller than 10 micrometers.

The frits thus obtained were used to prepare a conductive paste with a qualitative/quantitative composition similar to that of Example 1.

The sole difference consisted in the concentration of the glass frits which was 4% by weight compared to the 2.25% by weight used for the chemical frits in Example 1.

This difference was due to the smaller wafer etching efficiency of the glass frit and the consequent need to use a higher percentage thereof in order to obtain optimum performance characteristics.

The analogue paste with the same content of 2.25% by weight of glass frit was prepared, but it showed even worse electrical results and it is not reported here.

The paste thus obtained was used to prepare solar cells using the same method and the same firing conditions described in Example 1.

The electrical parameters obtained for 20 solar cells dried and fired in the conditions described in Example 1 were measured using a Berger cell tester CL4A-1.3600 R&D.

The average value for each parameter is shown in Table 1.

### EXAMPLE 3 (invention)

Preparation of a conductive paste comprising chemical frits based on lead salt with nanometric dimensions and obtained by means of direct wet-modified chemical synthesis.

Solution A was obtained by dissolving 55.2 g di Pb(NO₃)₂ in 100.7 g of deionized water. Solution B was obtained by dissolving 21.89 g of H₃BO₃ in 153 g of deionized water containing 25% by weight of an ammonia solution.

Solution A was then poured into solution B with vigorous stirring at 16°C until a white colloidal dispersion of PbBO₂·nH₂O particles with nanometric dimensions was obtained. In particular, the particles had dimensions smaller than 200 nanometers. In particular, more than 95%, by number, of the particles had dimensions smaller than 150 nanometers.

Evaluation of the diameters of the particles was performed in a qualitative manner by means of SEM microscopy on a sample prepared as described in A. Jillavenkatesa et al., "NIST Recommended Practice Guide: Particle Size Characterization", NIST SP - 960-1, January 2001, and measured by means of dynamic light scattering (DLS) on an aqueous solution of particles obtained as described in A. Jillavenkatesa et al., "NIST Recommended Practice Guide: Particle Size Characterization", and using the procedures described in the operating manual of the Malvern Zetasizer Nano ZS apparatus. The diffractometric analysis (XRD) was carried out using a Philips PW 1710 diffractometer on dried powder samples deposited on glass.

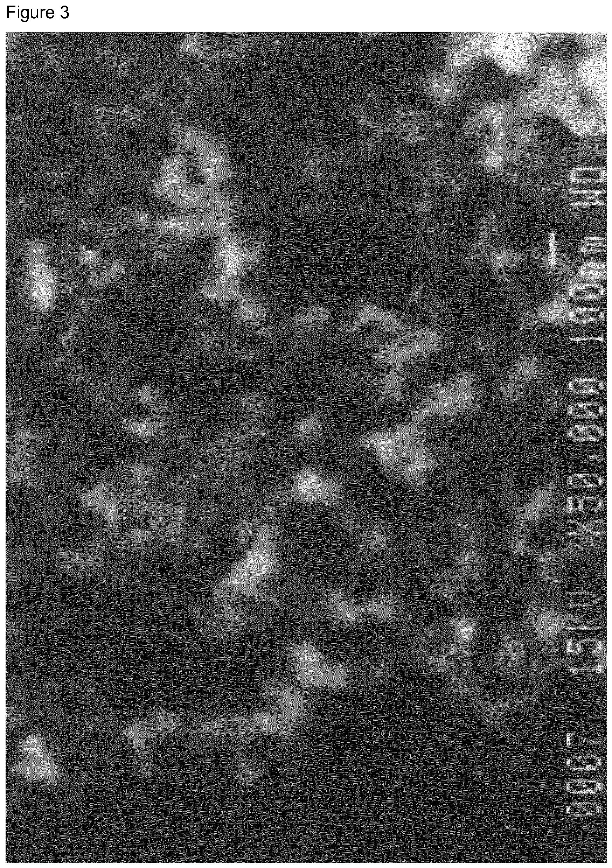

The analyses carried out by means of scanning electron microscopy (SEM), X-ray diffractometry (XRD) and dynamic light scattering DLS showed that the dispersion had a colloidal nature, and was composed of particles with nanometric dimensions and amorphous structure. Figure 3 shows a photograph (magnification factor: 50,000x), obtained using a SEM (scanning electron microscope). The mainly amorphous state of the granules obtained was characterized by the absence of well defined diffraction peaks, as known in the art and described, for example, in B.D. Cullity, Elements of X-ray Diffraction, Addison Wesley Mass. 1978 ISBN 0-201-01174-3.

The particles in colloidal form were separated and washed to remove undesired soluble salts. The material obtained was used to prepare a conductive paste with a qualitative/quantitative composition identical to that of Example 1.

However, unlike the paste obtained in Example 1, it was not required to carry out a further refinement of the conductive paste in a rotating-cylinder mill, since the paste already had a fine and homogeneous consistency suitable for being used directly in the screen printing process.

The paste thus obtained was used to prepare solar cells using the same method and the same firing conditions described in Example 1.

The electrical parameters obtained for 30 solar cells were measured using a Berger cell tester CL4A-1.3600 R&D.

The average value for each parameter is shown in Table 1.

### EXAMPLE 4 (invention)

Preparation of a conductive paste comprising chemical frits based on lead salt with nanometric dimensions and obtained in a colloidal dispersion by means of direct chemical synthesis as described by Lenher and Wolesensky, Journal of American Society, 1913, 35, pages 718-733.

Solution A was obtained by dissolving 20.0 g of K₂TeO₃·H₂O in 50 g of deionized water. Solution B was obtained by dissolving 25.57 g of Pb(NO₃)₂ in 50 g of deionized water.

Solution A and solution B were then mixed rapidly with vigorous stirring at 25°C until a suspension of particles of PbTeO₃·2H₂O was obtained. The particles in colloidal form were separated and washed to remove undesired soluble salts.

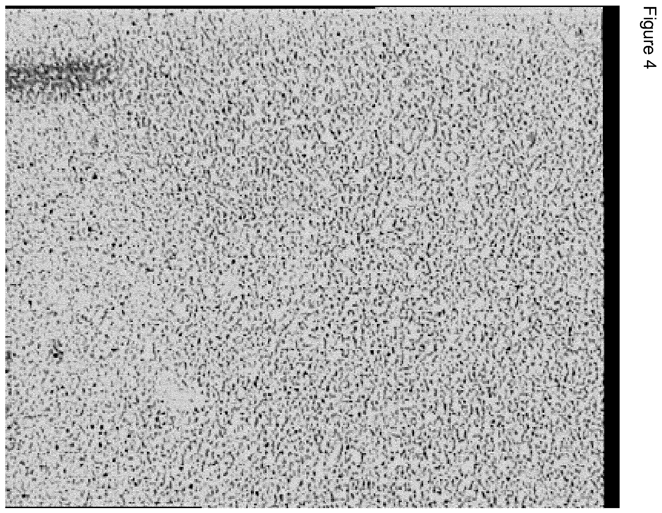

Figure 4 shows a photograph (magnification factor: 1000x), obtained using a transmitted-light optical microscope, of the suspension of particles of PbTeO₃·2H₂O thus obtained. Examination under a transmitted-light optical microscope reveals the homogeneity of the suspension of granules obtained and allows a rapid preliminary evaluation of the quality of the chemical frit.

Although optical microscopy is unable to achieve the resolution of particles with dimensions smaller than 200 nm diameter (Rayleigh criterion), the image is sufficient to show the homogeneity of the particle suspension and in particle the absence of particles with dimensions greater than this limit value.

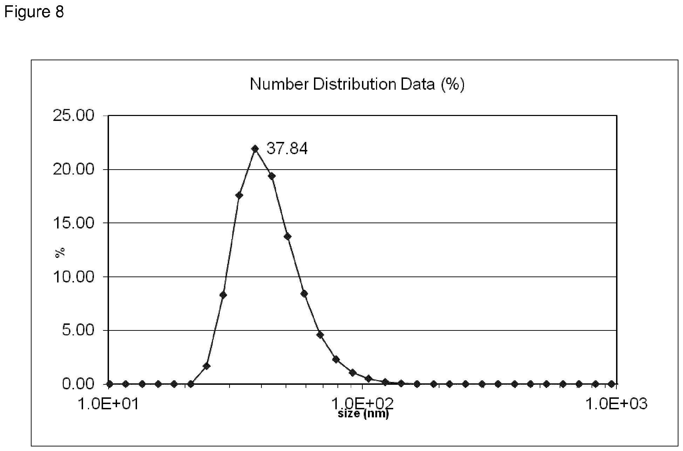

Furthermore, the particles had dimensions smaller than 500 nanometers. In particular, at least 95%, by number, of said particles had dimensions smaller than 200 nanometers. The dimensional distribution curve of the chemical frits thus obtained is shown in Figure 8. The curve was obtained by means of the dynamic light scattering (DLS) method using the Malvern Zetasizer Nano ZS apparatus.

The particles thus obtained were separated by means of flocculation/filtration.

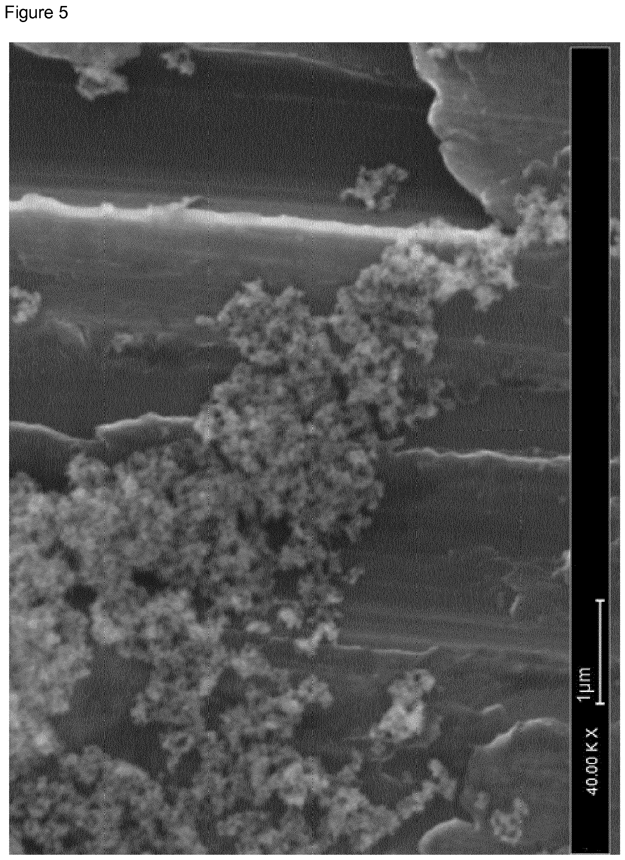

Microphotographs of the dried grains of the chemical frits thus obtained are shown in Figures 5, 6 and 7.

Figure 5 shows a photograph (magnification factor: 40,000x), obtained using a scanning electron microscope (SEM). The colloidal particles adhere to each other following elimination of the solvent. On the basis of the electron microscopy images it was possible to characterize the chemical frits in terms of size and shape. The particles had nanometric dimensions and a spheroidal shape.

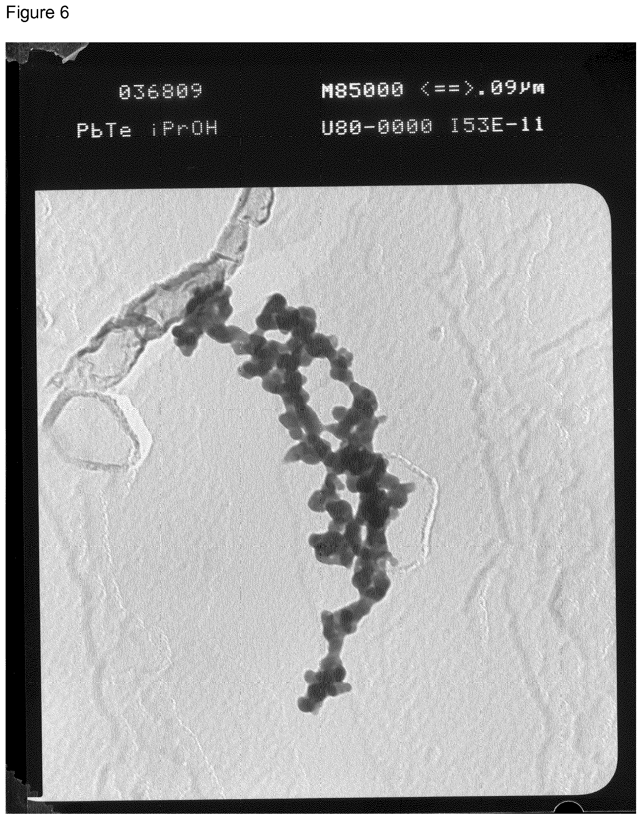

Figure 6 shows a photograph (magnification factor: 85,000x), obtained using a transmission electron microscope (TEM). The photograph showed, by means of comparison with the marker represented by the symbol ""<==>" (calibrated in accordance with "NIST Recommended Practice Guide: Particle Size Characterization", NIST SP - 960-1, January 2001"), that the particles had dimensions within the range of between 15 nm and 30 nm.

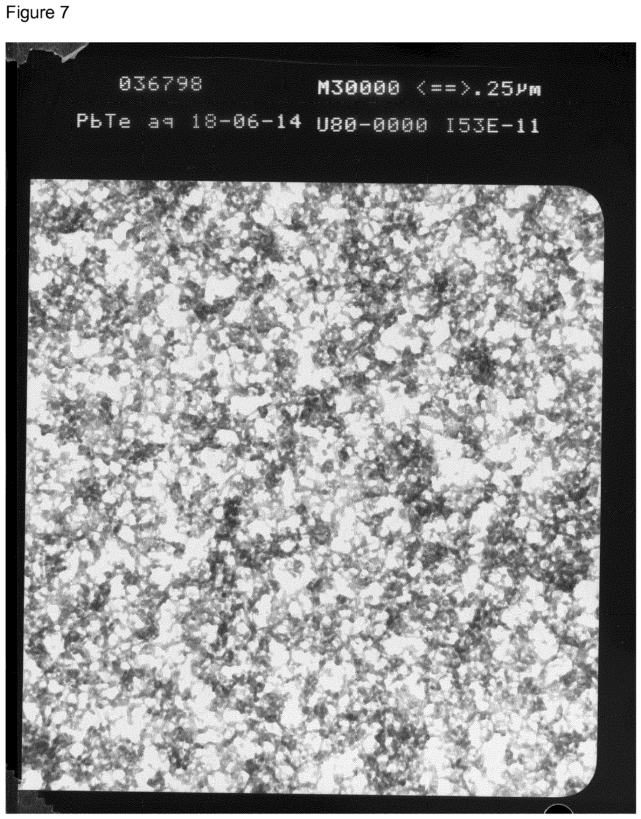

Figure 7 shows a photograph (magnification factor: 30,000x), obtained using a transmission electron microscope (TEM). The photograph shows how the particles, which have nanometric dimensions, formed a network of spheroidal aggregated particles following evaporation of the solvent. Despite the aggregation, the dimensional homogeneity of the particles already revealed under the optical microscope was fully confirmed.

The SEM, TEM and DLS analyses were carried out in accordance with the respective methods described in A. Jillavenkatesa et al., "NIST Recommended Practice Guide: Particle Size Characterization", NIST SP - 960-1, January 2001" and the DLS analyses conducted also in accordance with the instructions provided in the operating manual of the apparatus used (Malvern Zetasizer Nano ZS).

The samples for SEM examination were deposited on SEM metal stubs, while, for TEM examination, they were deposited on TEM grids with a graphite substrate.

The analysis by means of X-ray diffractometry (XRD) revealed the amorphous nature of the chemical frits obtained with the method described above. The amorphous nature of the precipitate obtained is highlighted by the absence of well-defined diffraction peaks, as well known in scientific literature, for example in B.D. Cullity, "Elements of X-ray Diffraction", Addison Wesley Mass. 1978 ISBN 0-201-01174-3.

The material obtained was used to prepare a conductive paste with a qualitative/quantitative composition identical to that of Example 1.

The paste thus obtained was used to prepare solar cells using the same method and the same firing conditions described in Example 1, except for the firing temperature, which was reduced to 935°C.

The electrical parameters obtained for 30 solar cells in the conditions described in Example 1 were measured using a Berger cell tester CL4A-1.3600 R&D.

The average value for each parameter is shown in Table 1.

**Table 1 - Average values of the electrical parameters obtained for the solar cells prepared in accordance with Examples 1 to 4.**

| | Efficiency % | Voc (V) | Rs (Ohm) | Rsh (Ohm) | Irev2 (A) | Isc (A) |
|---|---|---|---|---|---|---|
| Example 1(*) | 11.18 | 0.607 | 0.028 | 216.8 | 0.15 | 8.18 |
| Example 2(*) | 13.58 | 0.602 | 0.009 | 4.8 | 1.188 | 8.249 |
| Example 3(I) | 16.03 | 0.616 | 0.0046 | 59.1 | 0.384 | 8.44 |
| Example 4(I) | 16.08 | 0.622 | 0.004 | 23.5 | 0.24 | 8.488 |

| | | | | | | |
|---|---|---|---|---|---|---|
| (*): comparison (I): invention Efficiency: % conversion efficiency V_{oc}: open circuit voltage Rs: sheet resistance Rsh: shunt resistance Irev2: current measured at -14.5 V Isc: short-circuit current | | | | | | |

The data shown in Table 1 has solely a relative comparison value. The measurements were carried out in a laboratory environment under process and calibration conditions as similar as possible to each other. The values obtained are referable, but are not the same as the results which can be obtained in industrial plants.

The data obtained showed that the solar cells prepared using the pastes produced according to the present invention, as described in Examples 3 and 4, had a conversion efficiency superior to that of the solar cells prepared using the comparison methods described in Examples 1 and 2. The paste type 1 with 2.25% by weight of glass frit produced performance characteristics which were even inferior.

In particular, the data showed also that the conductive pastes in Examples 3 and 4 according to the present invention are more efficient at etching the antireflective layer and contacting the underlying wafer during the furnace firing process.

Moreover, the data showed that the conductive pastes used in Examples 3 and 4 according to the present invention facilitate the formation of a smooth and homogeneous glass at the interface with the n region of the wafer and moreover create better contact with the n region of the wafer.

## Claims

1. Conductive paste or ink comprising conductive metal particles, at least one organic solvent, and at least one organic additive, **characterized in that** said paste or ink comprises chemical frits wherein at least 95%, by number, of the particles of said chemical frits have dimensions smaller than 1 micrometer, and wherein said particles of said chemical frits consists of inorganic or organic metal salts.

2. Conductive paste or ink according to claim 1, **characterized in that** said chemical frits have a spheroidal shape.

3. Conductive paste or ink according to any one of the preceding claims, **characterized in that** said chemical frits comprise a simple salt, a mixed salt or a complex salt, formed by at least one metal cation and at least one anion.

4. Conductive paste or ink according to claim 3, **characterized in that** said at least one metal cation is selected from the group comprising metals of group III, group IV, group V and/or of block d.

5. Conductive paste or ink according to claim 4, **characterized in that** said at least one metal cation is selected from the group comprising thallium (TI), lead (Pb), tin (Sn), bismuth (Bi), antimony (Sb), nickel (Ni), copper (Cu), zinc (Zn) and silver (Ag).

6. Conductive paste or ink according to claim 3, **characterized in that** said at least one anion is selected from the group comprising carbonate, bicarbonate, borate, acetate, selenate, selenite, tellurate, tellurite, vanadate, silicate, fatty acid anions; and hydrates thereof.

7. Conductive paste or ink according to any one of the preceding claims, **characterized in that** said chemical frits have a melting temperature lower than 900°C, preferably lower than 750°C, and more preferably lower than 600°C.

8. Conductive paste or ink according to any one of the preceding claims, **characterized in that** said paste or ink comprises from 0.1% to 7% by weight, more preferably from 1.5% to 3.5% by weight of said chemical frits, with respect to the total weight of said conductive paste or ink.

9. Conductive paste or ink according to any one of the preceding claims, **characterized in that** said paste or ink comprises said chemical frits mixed with conventional glass frits.

10. Conductive paste or ink according to claim 9, **characterized in that** said paste or ink comprises from 0.05% to 7% by weight of said chemical frits with respect to the total weight of said paste or ink, and a percentage by weight, intentionally added, of said glass frits with respect to the total weight of said paste or ink greater than zero, and preferably between 0.01% and 3.5%.

11. Conductive paste or ink according to any one of the preceding claims, **characterized in that** said paste or ink comprises from 65% to 95% by weight of said conductive metal particles, with respect to the total weight of said paste or ink.

12. Conductive paste or ink according to any one of the preceding claims, **characterized in that** said paste or ink comprises from 2% to 20% of said organic solvent, with respect to the total weight of said paste or ink.

13. Conductive paste or ink according to any one of the preceding claims, **characterized in that** said organic additive is selected from the group comprising organic binders and surfactants.

14. A solar cell comprising a lamina of semiconductor material, an antireflective layer, an upper electrode and a lower electrode, **characterized in that** at least said upper electrode is formed by (i) applying on said antireflective layer a conductive paste or ink comprising conductive metal particles, at least one organic solvent, at least one organic additive and chemical frits, wherein at least 95%, by number, of the particles of said chemical frits have dimensions smaller than 1 micrometer, and wherein said particles of said chemical frits consists of inorganic or organic metal salts, and (ii) sintering said conductive paste or ink.

15. The solar cell according to claim 10, **characterized in that** said conductive paste or ink are as defined in any one of claims 2 to 9.

16. The solar cell according to claim 14 or 15, **characterized in that** said upper electrode comprises a first layer contacting the antireflective layer, and a second layer contacting said first layer, wherein at least said first layer is formed by using a conductive paste or ink as defined in any one of claims 1 to 13.

17. A method for forming a conductive element on the surface of a substrate, said method comprising (a) a step of applying on said surface a conductive paste or ink comprising conductive metal particles, at least one organic solvent, at least one organic additive and chemical frits, wherein at least 95%, by number, of the particles of said chemical frits have dimensions smaller than 1 micrometer, and wherein said particles of said chemical frits consists of inorganic or organic metal salts, and (b) a step of firing or sintering said conductive paste or ink.

18. The method according to claim 17, **characterized in that** said conductive element is an electrode, a printed circuit board, a conductive path or a resistor.

19. The method according to claim 17, **characterized in that** said substrate is a polymeric substrate, a paper sheet, insulating material or semiconductor material.

20. The method according to any one of claims 17 to 19, **characterized in that** said step (a) is performed by means of impregnation, dipping, pouring, dripping, injection, spraying, knife coating, brushing or printing, or a combination thereof.

21. The method according to any one of claims 17 to 19, **characterized in that** said step (b) is performed by firing or sintering, preferably at a temperature of between 400°C and 1,000°C, and preferably for a period of from 0.5 to 30 minutes.

## Patentansprüche

1. Leitfähige Paste oder Tinte, die leitfähige Metallpartikel, mindestens ein organisches Lösungsmittel und mindestens einen organischen Zusatzstoff umfasst, **dadurch gekennzeichnet, dass** die Paste oder Tinte chemische Fritten umfasst, wobei mindestens 95 %, durch Anzahl, der Partikel der chemischen Fritten Maße von kleiner als 1 Mikrometer aufweisen und wobei die Partikel der chemischen Fritten aus anorganischen oder organischen Metallsalzen bestehen.

2. Leitfähige Paste oder Tinte nach Anspruch 1, **dadurch gekennzeichnet, dass** die chemischen Fritten eine kugelige Form aufweisen.

3. Leitfähige Paste oder Tinte nach einem der vorhergehenden Ansprüche, **dadurch gekennzeichnet, dass** die chemischen Fritten ein einfaches Salz, ein Mischsalz oder ein Komplexsalz umfassen, das aus mindestens einem Metallkation und mindestens einem Anion gebildet wird.

4. Leitfähige Paste oder Tinte nach Anspruch 3, **dadurch gekennzeichnet, dass** das mindestens eine Metallkation ausgewählt ist aus der Gruppe umfassend Metalle der Gruppe III, Gruppe IV, Gruppe V und / oder des Blocks d.

5. Leitfähige Paste oder Tinte nach Anspruch 4, **dadurch gekennzeichnet, dass** das mindestens eine Metallkation ausgewählt ist aus der Gruppe umfassend Thallium (TI), Blei (Pb), Zinn (Sn), Bismut (Bi), Antimon (Sb), Nickel (Ni), Kupfer (Cu), Zink (Zn) und Silber (Ag).

6. Leitfähige Paste oder Tinte nach Anspruch 3, **dadurch gekennzeichnet, dass** das mindestens eine Anion ausgewählt ist aus der Gruppe umfassend Carbonat, Bicarbonat, Borat, Acetat, Selenat, Selenit, Tellurat, Tellurit, Vanadat, Silicat, Fettsäureanionen und Hydrate davon.

7. Leitfähige Paste oder Tinte nach einem der vorhergehenden Ansprüche, **dadurch gekennzeichnet, dass** die chemischen Fritten eine Schmelztemperatur von weniger als 900°C, bevorzugt weniger als 750°C und stärker bevorzugt weniger als 600°C aufweisen.

8. Leitfähige Paste oder Tinte nach einem der vorhergehenden Ansprüche, **dadurch gekennzeichnet, dass** die Paste oder Tinte von 0,1 Gew.-% bis 7 Gew.-%, stärker bevorzugt von 1,5 Gew.-% bis 3,5 Gew.-%, der chemischen Fritten umfasst, bezogen auf das Gesamtgewicht der leitfähigen Paste oder Tinte.

9. Leitfähige Paste oder Tinte nach einem der vorhergehenden Ansprüche, **dadurch gekennzeichnet, dass** die Paste oder Tinte die chemischen Fritten gemischt mit herkömmlichen Glasfritten umfasst.

10. Leitfähige Paste oder Tinte nach Anspruch 9, **dadurch gekennzeichnet, dass** die Paste oder Tinte von 0,05 Gew.-% bis 7 Gew.-% der chemischen Fritten bezogen auf das Gesamtgewicht der Paste oder Tinte und einen absichtlich hinzugefügten Gewichtsprozentsatz der Glasfritten bezogen auf das Gesamtgewicht der Paste oder Tinte größer als Null und bevorzugt zwischen 0,01% und 3,5% umfasst.

11. Leitfähige Paste oder Tinte nach einem der vorhergehenden Ansprüche, **dadurch gekennzeichnet, dass** die Paste oder Tinte von 65 Gew.-% bis 95 Gew.-% der leitfähigen Metallpartikel umfasst, bezogen auf das Gesamtgewicht der Paste oder Tinte.

12. Leitfähige Paste oder Tinte nach einem der vorhergehenden Ansprüche, **dadurch gekennzeichnet, dass** die Paste oder Tinte von 2% bis 20% des organischen Lösungsmittels umfasst, bezogen auf das Gesamtgewicht der Paste oder Tinte.

13. Leitfähige Paste oder Tinte nach einem der vorhergehenden Ansprüche, **dadurch gekennzeichnet, dass** der organische Zusatzstoff ausgewählt ist aus der Gruppe umfassend organische Bindemittel und Tenside.

14. Solarzelle, umfassend eine Platte aus Halbleitermaterial, eine Antireflexschicht, eine obere Elektrode und eine untere Elektrode, **dadurch gekennzeichnet, dass** mindestens die obere Elektrode gebildet wird durch (i) Aufbringen auf die Antireflexschicht eine leitfähige Paste oder Tinte umfassend leitfähige Metallpartikel, mindestens ein organisches Lösungsmittel, mindestens einen organischen Zusatzstoff und chemische Fritten, wobei mindestens 95 %, durch Anzahl, der Partikel der chemischen Fritten Maße von weniger als 1 Mikrometer aufweisen und wobei die Partikel der chemischen Fritten aus anorganischen oder organischen Metallsalzen bestehen, und (ii) Sintern der leitfähigen Paste oder Tinte.

15. Solarzelle nach Anspruch 10, **dadurch gekennzeichnet, dass** die leitfähige Paste oder Tinte wie in einem der Ansprüche 2 bis 9 definiert ist.

16. Solarzelle nach Anspruch 14 oder 15, **dadurch gekennzeichnet, dass** die obere Elektrode eine erste Schicht, die die Antireflexschicht kontaktiert, und eine zweite Schicht, die die erste Schicht kontaktiert, umfasst, wobei mindestens die erste Schicht unter Verwendung einer leitfähigen Paste oder Tinte wie in einem der Ansprüche 1 bis 13 definiert, gebildet wird.

17. Verfahren zum Bilden eines leitfähigen Elements auf der Oberfläche eines Substrats, wobei das Verfahren umfasst (a) einen Schritt des Aufbringens auf die Oberfläche eine leitfähige Paste oder Tinte umfassend leitfähige Metallpartikel, mindestens ein organisches Lösungsmittel, mindestens einen organischen Zusatzstoff und chemische Fritten, wobei mindestens 95 %, durch Anzahl, der Partikel der chemischen Fritten Maße von weniger als 1 Mikrometer aufweisen und wobei die Partikel der chemischen Fritten aus anorganischen oder organischen Metallsalzen bestehen, und (b) einen Schritt des Brennens oder Sinterns der leitfähigen Paste oder Tinte.

18. Verfahren nach Anspruch 17, **dadurch gekennzeichnet, dass** das leitfähige Element eine Elektrode, eine Leiterplatte, eine Leiterbahn oder ein Widerstand ist.

19. Verfahren nach Anspruch 17, **dadurch gekennzeichnet, dass** das Substrat ein Polymersubstrat, ein Papierblatt, Isoliermaterial oder Halbleitermaterial ist.

20. Verfahren nach einem der Ansprüche 17 bis 19, **dadurch gekennzeichnet, dass** der Schritt (a) mit Hilfe von Imprägnieren, Tauchen, Gießen, Tropfen, Injizieren, Spritzen, Rakeln, Streichen oder Drucken oder einer Kombination davon durchgeführt wird.

21. Verfahren nach einem der Ansprüche 17 bis 19, **dadurch gekennzeichnet, dass** der Schritt (b) durch Brennen oder Sintern durchgeführt wird, bevorzugt bei einer Temperatur von zwischen 400°C und 1000°C, und bevorzugt für einen Zeitraum von 0,5 bis 30 Minuten.

## Revendications

1. Pâte ou encre conductrice comprenant des particules de métal conducteur, au moins un solvant organique, et au moins un additif organique, **caractérisée en ce que** ladite pâte ou encre comprend des frittes chimiques où au moins 95 %, en nombre, des particules desdites frittes chimiques présentent des dimensions inférieures à 1 micromètre, et où lesdites particules desdites frittes chimiques sont constituées de sels métalliques inorganiques ou organiques.

2. Pâte ou encre conductrice selon la revendication 1, **caractérisée en ce que** lesdites frittes chimiques présentent une forme de sphéroïde.

3. Pâte ou encre conductrice selon l'une quelconque des revendications précédentes, **caractérisée en ce que** lesdites frittes chimiques comprennent un sel simple, un sel mixte ou un sel complexe, formé d'au moins un cation métallique et d'au moins un anion.

4. Pâte ou encre conductrice selon la revendication 3, **caractérisée en ce que** ledit au moins un cation métallique est sélectionné dans le groupe comprenant les métaux du groupe III, du groupe IV, du groupe V et/ou du bloc d.

5. Pâte ou encre conductrice selon la revendication 4, **caractérisée en ce que** ledit au moins un cation métallique est sélectionné dans le groupe comprenant le thallium (TI), le plomb (Pb), l'étain (Sn), le bismuth (Bi), l'antimoine (Sb), le nickel (Ni), le cuivre (Cu), le zinc (Zn) et l'argent (Ag).

6. Pâte ou encre conductrice selon la revendication 3, **caractérisée en ce que** ledit au moins un anion est sélectionné dans le groupe comprenant le carbonate, le bicarbonate, le borate, l'acétate, le sélénate, la sélénite, le tellurate, la tellurite, le vanadate, le silicate, les anions d'acide gras ; et leurs hydrates.

7. Pâte ou encre conductrice selon l'une quelconque des revendications précédentes, **caractérisée en ce que** lesdites frittes chimiques présentent une température de fusion inférieure à 900°C, préférablement inférieure à 750°C, et plus préférablement inférieure à 600°C.

8. Pâte ou encre conductrice selon l'une quelconque des revendications précédentes, **caractérisée en ce que** ladite pâte ou encre comprend de 0,1 % à 7 % en poids, plus préférablement de 1,5 % à 3,5 % en poids desdites frittes chimiques, par rapport au poids total de ladite pâte ou encre conductrice.

9. Pâte ou encre conductrice selon l'une quelconque des revendications précédentes, **caractérisée en ce que** ladite pâte ou encre comprend lesdites frittes chimiques mélangées avec des frittes de verre classiques.

10. Pâte ou encre conductrice selon la revendication 9, **caractérisée en ce que** ladite pâte ou encre comprend de 0,05 % à 7 % en poids desdites frittes chimiques par rapport au poids total de ladite pâte ou encre, et un pourcentage en poids, intentionnellement ajouté, desdites frittes de verre par rapport au poids total de ladite pâte ou encre supérieur à zéro, et préférablement entre 0,01 % et 3,5 %.

11. Pâte ou encre conductrice selon l'une quelconque des revendications précédentes, **caractérisée en ce que** ladite pâte ou encre comprend de 65 % à 95 % en poids desdites particules de métal conducteur, par rapport au poids total de ladite pâte ou encre.

12. Pâte ou encre conductrice selon l'une quelconque des revendications précédentes, **caractérisée en ce que** ladite pâte ou encre comprend de 2 % à 20 % dudit solvant organique, par rapport au poids total de ladite pâte ou encre.

13. Pâte ou encre conductrice selon l'une quelconque des revendications précédentes, **caractérisée en ce que** ledit additif organique est sélectionné dans le groupe comprenant les liants et les tensioactifs organiques.

14. Pile solaire comprenant une strate de matériau semi-conducteur, une couche antireflet, une électrode supérieure et une électrode inférieure, **caractérisée en ce qu'**au moins ladite électrode supérieure est formée par (i) l'application sur ladite couche antireflet d'une pâte ou d'encre conductrice comprenant des particules de métal conducteur, au moins un solvant organique, au moins un additif organique et des frittes chimiques, où au moins 95 %, en nombre, des particules desdites frittes chimiques présentent des dimensions inférieures à 1 micromètre, et où lesdites particules desdites frittes chimiques sont constituées de sels métalliques inorganiques ou organiques, et (ii) le frittage de ladite pâte ou encre conductrice.

15. Pile solaire selon la revendication 10, **caractérisée en ce que** ladite pâte ou encre conductrice sont telles que définies selon l'une quelconque des revendications 2 à 9.

16. Pile solaire selon la revendication 14 ou 15, **caractérisée en ce que** ladite électrode supérieure comprend une première couche entrant en contact avec la couche antireflet, et une seconde couche entrant en contact avec ladite première couche, où au moins ladite première couche est formée en utilisant une pâte ou une encre conductrice telle que définie selon l'une quelconque des revendications 1 à 13.

17. Procédé de formation d'un élément conducteur sur la surface d'un substrat, ledit procédé comprenant (a) une étape d'application sur ladite surface d'une pâte ou encre conductrice comprenant les particules de métal conducteur, au moins un solvant organique, au moins un additif organique et des frittes chimiques, où au moins 95 %, en nombre, des particules desdites frittes chimiques présentent des dimensions inférieures à 1 micromètre, et où lesdites particules desdites frittes chimiques sont constituées de sels métalliques inorganiques ou organiques, et (b) une étape de calcination ou de frittage de ladite pâte ou encre conductrice.

18. Procédé selon la revendication 17, **caractérisé en ce que** ledit élément conducteur est une électrode, un panneau de circuit imprimé, un chemin conducteur ou une résistance.

19. Procédé selon la revendication 17, **caractérisé en ce que** ledit substrat est un substrat polymère, une feuille de papier, un matériau isolant ou un matériau semi-conducteur.

20. Procédé selon l'une quelconque des revendications 17 à 19, **caractérisé en ce que** ladite étape (a) est effectuée par imprégnation, immersion, coulée, goutte à goutte, injection, pulvérisation, couchage à la lame, brossage ou impression, ou une combinaison de ceux-ci.

21. Procédé selon l'une quelconque des revendications 17 à 19, **caractérisé en ce que** ladite étape (b) est effectuée par calcination ou frittage, préférablement à une température comprise entre 400°C et 1 000°C, et préférablement sur une durée de 0,5 à 30 minutes.
